(19) 

Europäisches
Patentamt
European
Patent Office
Office européen
des brevets

(11) **EP 4 361 650 A1**

(12) **EUROPEAN PATENT APPLICATION**
published in accordance with Art. 153(4) EPC

(43) Date of publication:
**01.05.2024 Bulletin 2024/18**

(21) Application number: **21951327.2**

(22) Date of filing: **30.07.2021**

(51) International Patent Classification (IPC):
*G01R 31/3185* (2006.01)    *G01R 31/28* (2006.01)

(52) Cooperative Patent Classification (CPC):
**G01R 31/28; G01R 31/3185**

(86) International application number:
**PCT/CN2021/109508**

(87) International publication number:
**WO 2023/004731 (02.02.2023 Gazette 2023/05)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **Huawei Technologies Co., Ltd.
Shenzhen, Guangdong 518129 (CN)**

(72) Inventors:
 • **WANG, Zezhong
  Shenzhen, Guangdong 518129 (CN)**

 • **HUANG, Yu
  Shenzhen, Guangdong 518129 (CN)**
 • **ZHANG, Weiwei
  Shenzhen, Guangdong 518129 (CN)**
 • **WANG, Naixing
  Shenzhen, Guangdong 518129 (CN)**
 • **LI, Pengju
  Shenzhen, Guangdong 518129 (CN)**

(74) Representative: **Huawei European IPR
Huawei Technologies Duesseldorf GmbH
Riesstraße 25
80992 München (DE)**

(54) **METHOD FOR DESIGNING TEST CIRCUIT, AND ELECTRONIC DEVICE**

(57)   This disclosure relates to a method for designing a test circuit, an apparatus, and a device. The method includes determining a feature of a to-be-tested circuit based on data representing the to-be-tested circuit. The method further includes determining switch distribution for the to-be-tested circuit based on the feature of the to-be-tested circuit. The switch distribution represents distribution, in a two-dimensional switch matrix circuit, of a plurality of switches that are in a test circuit and that are coupled to a plurality of scan chains of the to-be-tested circuit. The switch matrix circuit includes a plurality of rows and a plurality of columns, any one of the plurality of rows has at least one of the plurality of switches, and any one of the plurality of columns has at least one of the plurality of switches. In this manner, switch distribution for a low-power control module and a mask control module may be determined, so as to reduce a quantity of scan chains that are additionally enabled in an input phase and improve accuracy of disabling, in an output phase, a scan chain that has an X state, thereby optimizing test power consumption and improving test accuracy.

FIG. 1

**EP 4 361 650 A1**

**Description**

**TECHNICAL FIELD**

This disclosure relates to the electronics field, and in particular, to a method for designing a test circuit and an electronic device.

**BACKGROUND**

In chip manufacturing and packaging processes, a chip inevitably has a defect for various reasons (for example, due to techniques and materials), and such defect causes the chip to fail to work normally. A main task of chip testing is to select the defective chip. Because overheads brought if the defective chip flows into the market are far greater than overheads of the chip testing, the chip testing is an important part in the chip manufacturing process.

Specifically, a design for testability (design for testability, DFT) structure such as a scan chain (scan chain) may be added to a chip in a chip design phase, and the chip having the DFT structure is manufactured. A chip test pattern (test pattern) may be generated by using an automatic test pattern generation (automatic test pattern generation, ATPG) tool, and the test pattern is input to a to-be-tested chip by using automatic test equipment (automatic test equipment, ATE). Whether a response of the to-be-tested chip is consistent with an expected response is compared, so that a quality test can be performed immediately after production is completed.

With continuously increasing integration and complexity of the chip, a data amount of a required test pattern set also increases rapidly. Consequently, time of the chip testing is increased by several times, and the increased testing time also greatly increases test costs. To alleviate this problem, a test compression technology is developed. However, the conventional test compression technology has problems such as a large quantity of encoded bits or high hardware overheads.

**SUMMARY**

In view of the foregoing problems, embodiments of this disclosure are intended to provide a method for designing a test circuit, an apparatus, and a device. The test circuit is configured to test a to-be-tested circuit in a same chip.

According to a first aspect of this disclosure, a method for designing a test circuit is provided. The method includes: determining a feature of a to-be-tested circuit based on netlist data representing the to-be-tested circuit, where the to-be-tested circuit is designed to be coupled to the test circuit in a chip, and the feature of the to-be-tested circuit includes at least one of scan chain distribution or unknown state distribution of the to-be-tested circuit. The method further includes: determining switch distribution for the to-be-tested circuit based on the feature of the to-be-tested circuit, where the switch distribution represents distribution, in a two-dimensional switch matrix circuit, of a plurality of switches that are in the test circuit and that are coupled to a plurality of scan chains of the to-be-tested circuit, the two-dimensional switch matrix circuit includes a plurality of rows and a plurality of columns, any one of the plurality of rows has at least one of the plurality of switches, any one of the plurality of columns has at least one of the plurality of switches, and the plurality of switches are selectively turned on or off based on logical levels of the plurality of rows and the plurality of columns. Compared with a conventional XOR gate network, the two-dimensional switch matrix circuit has fewer encoded bits and an improved encoding success rate thanks to a row-column arrangement manner of decoding switches in the two-dimensional switch matrix circuit. In addition, a system of linear equations does not need to be solved in the two-dimensional switch matrix circuit, so that requirements for computing resources can be reduced.

In some implementations of the first aspect, the determining switch distribution for the to-be-tested circuit based on the feature of the to-be-tested circuit includes: determining one or more pieces of alternative switch distribution based on the feature of the to-be-tested circuit; obtaining, by using the one or more pieces of alternative switch distribution, one or more encoding success rates corresponding to the one or more pieces of alternative switch distribution; and selecting the switch distribution for the to-be-tested circuit from the one or more pieces of alternative switch distribution at least based on the one or more encoding success rates. An encoding success rate of each piece of alternative switch distribution is calculated, and switch distribution with a higher encoding success rate may be selected as the switch distribution for the to-be-tested circuit. This can further improve the encoding success rate of the test circuit.

In some implementations of the first aspect, the determining one or more pieces of alternative switch distribution based on the feature of the to-be-tested circuit includes: obtaining an initial sparsity based on the feature of the to-be-tested circuit, where the initial sparsity represents an initial sparsity degree of the plurality of switches relative to all nodes in the rows and the columns of the two-dimensional switch matrix circuit; calculating a quantity of rows and a quantity of columns of the switch distribution by using the initial sparsity; and determining the one or more pieces of alternative switch distribution at an even granularity based on the quantity of rows and the quantity of columns, where the even granularity indicates that a difference between quantities of switches in any two of the plurality of rows is not greater than 1, and a difference between quantities of switches in any two of the plurality of columns is not greater than 1. Because each row and each column have switches with a substantially identical or similar quantity, this may minimize a total quantity of switches that are turned on by mistake. Therefore, setting a sparse two-dimensional switch matrix circuit as a coefficient matrix with the even granularity can improve the encoding success rate.

In some implementations of the first aspect, the determining the one or more pieces of alternative switch distribution at an even granularity based on the quantity of rows and the quantity of columns includes: determining, at the even granularity based on the quantity of rows and the quantity of columns, a plurality of nodes at which switches are to be disposed and that are in the two-dimensional switch matrix circuit; and disposing the plurality of switches at the plurality of nodes in a random manner to determine the one or more pieces of alternative switch distribution.

In some implementations of the first aspect, the determining the one or more pieces of alternative switch distribution at an even granularity based on the quantity of rows and the quantity of columns includes: determining, at the even granularity based on the quantity of rows and the quantity of columns, a plurality of nodes at which switches are to be disposed and that are in the two-dimensional switch matrix circuit; and disposing, at the plurality of nodes in a spiral manner from a center to a periphery based on use frequency of the plurality of scan chains, the plurality of switches corresponding to the plurality of scan chains, so as to determine the one or more pieces of alternative switch distribution, where a switch that is in the plurality of switches and that corresponds to a scan chain, with highest use frequency, in the plurality of scan chains is disposed at a central node in the plurality of nodes. The switch distribution is determined based on the use frequency of the scan chains, so that a stronger encoding capability can be implemented while a quantity of encoded bits is not increased. In addition, the switch distribution is iteratively learned based on the encoding success rate and the sparsity, and overall optimization of hardware overheads and the encoding capability can be implemented.

In some implementations of the first aspect, the determining the one or more pieces of alternative switch distribution at an even granularity based on the quantity of rows and the quantity of columns includes: determining, at the even granularity based on the quantity of rows and the quantity of columns, a plurality of nodes at which switches are to be disposed and that are in the two-dimensional switch matrix circuit; and disposing, at the plurality of nodes in a spiral manner from a center to a periphery based on use correlation of the plurality of scan chains, the plurality of switches corresponding to the plurality of scan chains, so as to determine the one or more pieces of alternative switch distribution, where use correlation of scan chains corresponding to two switches that are adjacent in a first direction or a second direction and that are in the plurality of switches is greater than use correlation of scan chains corresponding to two other switches that are not adjacent in the first direction or the second direction and that are in the plurality of switches, and the first direction is perpendicular to the second direction. The switch distribution is determined based on use frequency and the use correlation of the scan chains, so that a stronger encoding capability can be implemented while a quantity of encoded bits is not increased.

In some implementations of the first aspect, the determining the switch distribution for the to-be-tested circuit at least based on the one or more encoding success rates includes: comparing the one or more encoding success rates with a success rate threshold to determine a first alternative switch distribution set, where each alternative switch distribution in the first alternative switch distribution set has an encoding success rate higher than the success rate threshold; and determining alternative switch distribution that is in the first alternative switch distribution set and that has a minimum sparsity as the switch distribution for the to-be-tested circuit. The switch distribution that has the minimum sparsity is selected while the encoding success rate is ensured. This can reduce hardware overheads.

In some implementations of the first aspect, the determining a feature of a to-be-tested circuit based on netlist data representing the to-be-tested circuit includes: determining the scan chain distribution of the to-be-tested circuit based on a netlist file that describes the to-be-tested circuit.

In some implementations of the first aspect, the determining the scan chain distribution of the to-be-tested circuit based on a netlist file includes: generating a test pattern based on the netlist file; and determining the scan chain distribution based on the test pattern.

In some implementations of the first aspect, the determining a feature of a to-be-tested circuit based on netlist data representing the to-be-tested circuit includes: determining the unknown state distribution of the to-be-tested circuit based on a netlist file that describes the to-be-tested circuit.

According to a second aspect of this disclosure, a computer-readable storage medium is provided, and stores a plurality of programs. The plurality of programs are configured to be executed by one or more processors, and the plurality of programs include instructions for performing the method in the first aspect.

According to a third aspect of this disclosure, a computer program product is provided. The computer program product includes a plurality of programs, the plurality of programs are configured to be executed by one or more processors, and the plurality of programs include instructions for performing the method in the first aspect.

According to a fourth aspect of this disclosure, an electronic device is provided. The electronic device includes one or more processors and a memory including computer instructions. When the computer instructions are executed by the one or more processors of the electronic device, the electronic device is enabled to perform the method in the first aspect.

According to a fifth aspect of this disclosure, an electronic device is provided. The electronic device includes a feature determining unit and a switch distribution determining unit. The feature determining unit is configured to determine a feature of a to-be-tested circuit based on netlist data representing the to-be-tested circuit, where the to-be-tested circuit is designed to be coupled to a test circuit in a chip, and the feature of the to-be-tested circuit includes at least one of scan chain distribution or unknown state distribution of the to-be-tested circuit. The switch distribution determining unit is configured to determine switch distribution for the to-be-tested circuit based on the feature of the to-be-tested circuit, where the switch distribution represents distribution, in a two-dimensional switch matrix circuit, of a plurality of switches that are in the test circuit and that are coupled to a plurality of scan chains of the to-be-tested circuit, the two-dimensional switch matrix circuit includes a plurality of rows and a plurality of columns, any one of the plurality of rows has at least one of the plurality of switches, any one of the plurality of columns has at least one of the plurality of switches, and the plurality of switches are selectively turned on or off based on logical levels of the plurality of rows and the plurality of columns. Compared with a conventional XOR gate network, the two-dimensional switch matrix circuit has fewer encoded bits and an improved encoding success rate thanks to a row-column arrangement manner of decoding switches in the two-dimensional switch matrix circuit. In addition, a system of linear equations does not need to be solved in the two-dimensional switch matrix circuit, so that requirements for computing resources can be reduced.

In some implementations of the fifth aspect, the switch distribution determining unit is further configured to: determine one or more pieces of alternative switch distribution based on the feature of the to-be-tested circuit; obtain, by using the one or more pieces of alternative switch distribution, one or more encoding success rates corresponding to the one or more pieces of alternative switch distribution; and select the switch distribution for the to-be-tested circuit from the one or more pieces of alternative switch distribution at least based on the one or more encoding success rates. An encoding success rate of each piece of alternative switch distribution is calculated, and switch distribution with a higher encoding success rate may be selected as the switch distribution for the to-be-tested circuit. This can further improve the encoding success rate of the test circuit.

In some implementations of the fifth aspect, the switch distribution determining unit is further configured to: obtain an initial sparsity based on the feature of the to-be-tested circuit, where the initial sparsity represents an initial sparsity degree of the plurality of switches relative to all nodes in the rows and the columns of the two-dimensional switch matrix circuit; calculate a quantity of rows and a quantity of columns of the switch distribution by using the initial sparsity; and determine the one or more pieces of alternative switch distribution at an even granularity based on the quantity of rows and the quantity of columns, where the even granularity indicates that a difference between quantities of switches in any two of the plurality of rows is not greater than 1, and a difference between quantities of switches in any two of the plurality of columns is not greater than 1.

In some implementations of the fifth aspect, the switch distribution determining unit is further configured to: determine, at the even granularity based on the quantity of rows and the quantity of columns, a plurality of nodes at which switches are to be disposed and that are in the two-dimensional switch matrix circuit; and dispose the plurality of switches at the plurality of nodes in a random manner to determine the one or more pieces of alternative switch distribution. Because each row and each column have switches with a substantially identical or similar quantity, this may minimize a total quantity of switches that are turned on by mistake. Therefore, setting a sparse two-dimensional switch matrix circuit as a coefficient matrix with the even granularity can improve the encoding success rate.

In some implementations of the fifth aspect, the switch distribution determining unit is further configured to: determine, at the even granularity based on the quantity of rows and the quantity of columns, a plurality of nodes at which switches are to be disposed and that are in the two-dimensional switch matrix circuit; and dispose, at the plurality of nodes in a spiral manner from a center to a periphery based on use frequency of the plurality of scan chains, the plurality of switches corresponding to the plurality of scan chains, so as to determine the one or more pieces of alternative switch distribution, where a switch that is in the plurality of switches and that corresponds to a scan chain, with highest use frequency, in the plurality of scan chains is disposed at a central node in the plurality of nodes. The switch distribution is determined based on the use frequency of the scan chains, so that a stronger encoding capability can be implemented while a quantity of encoded bits is not increased. In addition, the switch distribution is iteratively learned based on the encoding success rate and the sparsity, and overall optimization of hardware overheads and the encoding capability can be implemented.

In some implementations of the fifth aspect, the switch distribution determining unit is further configured to: determine, at the even granularity based on the quantity of rows and the quantity of columns, a plurality of nodes at which switches are to be disposed and that are in the two-dimensional switch matrix circuit; and dispose, at the plurality of nodes in a spiral manner from a center to a periphery based on use correlation of the plurality of scan chains, the plurality of switches corresponding to the plurality of scan chains, so as to determine the one or more pieces of alternative switch distribution, where use correlation of scan chains corresponding to two switches that are adjacent in a first direction or a second direction and that are in the plurality of switches is greater than use correlation of scan chains corresponding to two other switches that are not adjacent in the first direction or the second direction and that are in the plurality of switches, and the first direction is perpendicular to the second direction. The switch distribution is determined based on use frequency and the use correlation of the scan chains, so that a stronger encoding capability can be implemented while a quantity of encoded bits is not increased.

In some implementations of the fifth aspect, the switch distribution determining unit is further configured to: compare the one or more encoding success rates with a success rate threshold to determine a first alternative switch distribution set, where each alternative switch distribution in the first alternative switch distribution set has an encoding success rate higher than the success rate threshold; and determine alternative switch distribution that is in the first alternative switch distribution set and that has a minimum sparsity as the switch distribution for the to-be-tested circuit. The switch distribution that has the minimum sparsity is selected while the encoding success rate is ensured. This can reduce hardware overheads.

It should be understood that content described in the summary part is not intended to limit key or important features of embodiments of this disclosure, and is not intended to limit the scope of this disclosure. Other features of this disclosure may be readily understood from the following descriptions.

**BRIEF DESCRIPTION OF DRAWINGS**

The foregoing and other features, advantages, and aspects of embodiments of this disclosure become more apparent with reference to the accompanying drawings and the following detailed descriptions. In the accompanying drawings, identical or similar reference numerals indicate identical or similar elements.

FIG. 1 is a schematic diagram of a structure of a chip 100 to which a test compression technology is applied according to some embodiments of this disclosure;
FIG. 2 is a schematic diagram of a two-dimensional switch matrix circuit 200 used in a low-power decoder 142 and a mask decoder 152 according to some embodiments of this disclosure;
FIG. 3 is a schematic diagram of a sparse two-dimensional switch matrix circuit 300 used in a low-power decoder 142 and a mask decoder 152 according to some embodiments of this disclosure;
FIG. 4 is a schematic flowchart of a method 400 for determining switch distribution for a to-be-tested circuit 11 according to some embodiments of this disclosure;
FIG. 5 is a schematic flowchart of a method 500 for determining switch distribution according to some embodiments of this disclosure;
FIG. 6 is a schematic diagram of spiral winding determined based on use correlation of scan chains according to some embodiments of this disclosure;
FIG. 7 is a schematic block diagram of an electronic device 700 according to some embodiments of this disclosure; and
FIG. 8 is a schematic block diagram of an example device 800 that may be used to implement embodiments of this disclosure.

**DESCRIPTION OF EMBODIMENTS**

Embodiments of this disclosure are described in more detail in the following with reference to the accompanying drawings. Although some embodiments of this disclosure are shown in the accompanying drawings, it should be understood that this disclosure may be implemented in various forms, and should not be construed as being limited to embodiments described herein. On the contrary, these embodiments are provided for a more thorough and complete understanding of this disclosure. It should be understood that the accompanying drawings and embodiments of this disclosure are merely used as examples, but are not intended to limit the protection scope of this disclosure.

In descriptions of embodiments of this disclosure, the term "include" and similar terms thereof should be understood as open inclusion, that is, "include but are not limited to". The term "based on" should be understood as "at least partially based on". The terms "one embodiment" or "the embodiment" should be understood as "at least one embodiment". The terms "first", "second", and the like may indicate different or same objects. The term "and/or" represents at least one of two items associated with the term. For example, "A and/or B" indicates A, B, or A and B. Other explicit and implicit definitions may also be included below.

It should be understood that, in the following descriptions of specific embodiments of the technical solutions provided in embodiments of this application, some repeated parts may not be described again, but it should be considered that the specific embodiments are mutually referenced and may be combined with each other.

In an electronic design automation (electronic design automation, EDA) design process of a chip, a user inputs a configuration to EDA software, the EDA software generates a logic circuit, and then the chip is obtained through plate-making and tape-out. In a process of testing the chip, the chip may be mounted on ATE, and the ATE inputs test excitation to an input pin of an IC chip. A response of an output pin of the chip and an expected response are compared to determine whether the chip is qualified. As described above, with continuously increasing integration and complexity of the chip, a required test pattern set also increases rapidly. This leads to an increase in chip testing costs. In order to control the testing costs, a test compression technology is proposed to ensure test coverage (test coverage) while a test pattern is compressed. The test compression technology is based on a scan chain. A scan chain technology is essentially to connect flip-flops in a sequential circuit to form a plurality of "scan cells (scan cells)", and input and output values of each scan cell can be observed independently.

Feasibility of the test compression technology is based on a fact that a single original test pattern generated by an ATPG includes input values on all scan cells that are on a scan chain while only input values on a few scan cells are valid values. Therefore, the original test pattern may be compressed, and a decompression module (decompressor) is excited to perform decompression to restore the valid values. In addition, output values on the scan chain may also be compressed by a compression module (compactor). An output compressed value is sent to the ATE through the output pin. The ATE compares the output compressed value with an expected value to locate a position of a scan cell, of the scan chain, on which an error occurs.

In the test compression technology, compression ratios of the input values and the output values of the scan cells of the scan chain can usually reach hundreds or thousands, so that a data amount of test patterns is greatly reduced. But at the same time, two core problems in the field of test compression are caused. A first problem is about power consumption. A quantity of valid values of original input values of scan cells is very small (the valid values are sparse), and therefore shift power consumption on a scan chain in an input phase is also very small. However, input compressed values are usually no longer sparse after decompression. In a process of directly shifting decompressed values to corresponding scan cells, intolerable shift power consumption is generated. This causes a decrease in a yield rate of chip testing and a decrease in test stability, and even causes a result such as burning of the chip due to overheating during testing. A second problem is about masking by unknown states (X states) generated in a test process. Some circuit modules have unknown functions, and output some unknown values (unknown values) that are unpredictable. These unknown values are called X states. Some circuits that generate the X states are distributed on a scan chain, and these X states are distributed on output values of the scan chain. When a compression module performs compression, these X states mask valid values of other circuits that synchronously perform compression, resulting in unobservable related positions in the circuits. This results in a decrease in fault coverage, an increase in a quantity of test patterns, or the like.

In a conventional solution, a low-power control module and a mask control module are separately introduced to resolve the foregoing two problems. The low-power control module and the mask control module are similar in functions, and both are decoders. A decoding output of the low-power control module controls an input value of a scan chain. When the decoding output is 0, a fixed value is input to a scan cell that is on the controlled scan chain; otherwise, an output value of a decompression module is input to a scan cell that is on the controlled scan chain. A decoding output of the mask control module controls a value input by a corresponding scan chain to a compression module. When the decoding output is 0, the value input by the controlled scan chain to the compression module is clamped to a fixed value; otherwise, an output value of the controlled scan chain is input to the compression module. The decoding outputs of the two control modules are connected to each scan chain, and a value of the decoding output is set to 1 or 0 to enable or disable the corresponding scan chain. The low-power control module sets a state of a scan chain including a valid input value to an enabled state, to allow excitation of the decompression module to input a shift value to a scan chain that is in a to-be-tested circuit, and the mask control module sets a state of a scan chain including X-state output to a disabled state, to prevent X-state output of a scan chain that is in the to-be-tested circuit. For example, in some conventional solutions, an XOR gate network may be used to form a decoder. Logic gates used in the XOR gate network are an XOR gate and an AND gate. Generally, in this structure, a value obtained through an XOR operation performed by using three encoded bits represents a control state of a corresponding scan chain. For the low-power control module, when an input shift power consumption threshold set by a user is low, more encoded bits are used in this structure, and an AND operation is further performed on a plurality of output values of an XOR network structure to control a scan chain. However, in this XOR gate network structure, a large quantity of encoded bits are used, an encoding capability is slightly improved by increasing the encoded bits, and hardware overheads are high. In addition, in a conventional XOR gate network, a system of linear equations needs to be solved during encoding, there is a specific requirement on complexity of a solution algorithm, and overheads of computing resources are also high.

In some embodiments of this disclosure, a two-dimensional switch matrix circuit is designed as a control circuit of a decoder. A plurality of switches are set in rows and columns of the two-dimensional switch matrix circuit. Some or all switches in the two-dimensional switch matrix circuit are coupled to scan chains to control enabling or disabling of the scan chains. Therefore, the switches in the two-dimensional switch matrix circuit may be controlled by using row encoded bits and column encoded bits (referred to as row encoded bits and column encoded bits below). Compared with a conventional XOR gate network, the two-dimensional switch matrix circuit has fewer encoded bits and an improved encoding success rate thanks to a row-column arrangement manner of decoding switches in the two-dimensional switch matrix circuit. In addition, a system of linear equations does not need to be solved in the two-dimensional switch matrix circuit, so that requirements for computing resources can be reduced.

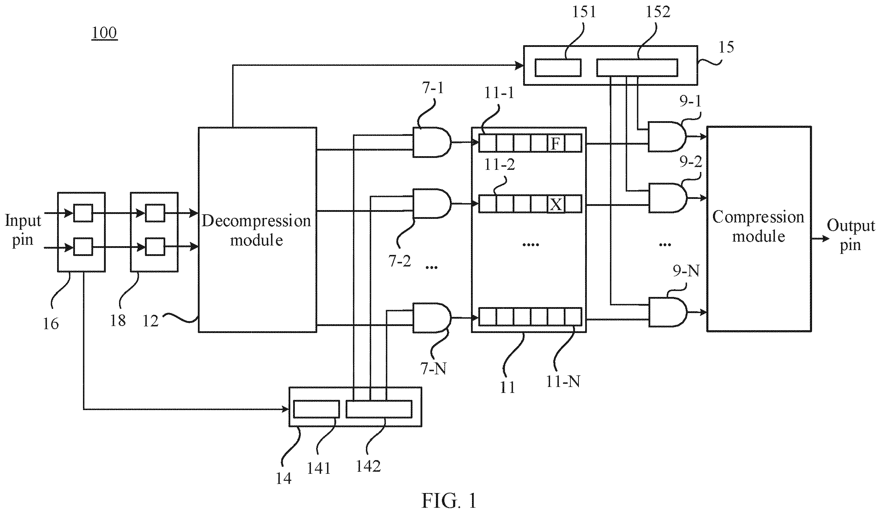

FIG. 1 is a schematic diagram of a structure of a chip 100 to which a test compression technology is applied according to some embodiments of this disclosure. As shown in FIG. 1, the chip 100 includes a to-be-tested circuit 11, a low-power scan cell 16, a mask register 18, a decompression module 12, a compression module 13, a low-power controller 14, a mask controller 15, a plurality of AND gates 7-1, 7-2, ..., 7-N, and a plurality of AND gates 9-1, 9-2, ..., 9-N, where N represents an integer greater than 1. In the chip 100, the low-power scan cell 16, the mask register 18, the decompression module 12, the compression module 13, the low-power controller 14, the mask controller 15, the plurality of AND gates 7-1, 7-2, ..., 7-N, and the plurality of AND gates 9-1, 9-2, ..., 9-N are configured to test the to-be-tested circuit 11. Therefore, in an embodiment, a test circuit of the chip 100 may include at least one of the low-power controller 14 or the mask controller 15. In another embodiment, the test circuit of the chip 100 may further include the low-power scan cell 16, the mask register 18, the decompression module 12, the compression module 13, the plurality of AND gates 7-1, 7-2, ..., 7-N, and the plurality of AND gates 9-1, 9-2, ..., 9-N. When an actual test is performed on the chip 100, ATE inputs an ATPG test pattern to the low-power scan cell 16 of the chip 100 through a few input pins of the chip 100. The ATPG test pattern includes an input compressed value, namely, a compressed seed (compressed seed), of the decompression module 12, an encoded value of the low-power controller 14, an encoded value of the mask controller 15, and the like. The input compressed value is injected into the decompression module 12 through the low-power scan cell 16 and the mask register 18. The encoded value of the low-power controller 14 is injected into the low-power controller 14 through the low-power scan cell 16, and the encoded value of the mask controller 15 is injected into the mask controller 15 through the low-power scan cell 16 and the mask register 18. In an input phase, the low-power controller 14 decodes the encoded value to enable an appropriate scan chain. The decompression module 12 decompresses the input compressed value of the decompression module 12, and fills a decompressed value into a corresponding scan cell under the control of the low-power controller 14 through shifting.

In an output phase, the mask controller 15 decodes the encoded value, masks an X state in an output value of a scan chain by using a decoded bit value, and sends a processed output value to the compression module 13 for compression. In an embodiment, the to-be-tested circuit 11 includes a plurality of scan chains 11-1, 11-2, ..., 11-N (which are separately or collectively referred to as 11 below), and a quantity of scan chains corresponds to a quantity of a plurality of AND gates 7-1, 7-2, ..., 7-N (which are separately or collectively referred to as 7 below) and a quantity of a plurality of AND gates 9-1, 9-2, ..., 9-N (which are separately or collectively referred to as 9 below). Each scan chain may include one or more sequential logic circuits, such as one or more registers, in the to-be-tested circuit. The low-power controller 14 includes a low-power register 141 and a decoder 142. The decoder 142 generates a control signal through decoding to control one or more of the AND gates 7-1, 7-2, ..., 7-N to be turned on or off. For example, within a plurality of periodicities, the decoder 142 may continuously generate logical values "1" and send them to the AND gate 7-1, so that decompressed values are continuously shifted and input to the scan chain 11-1. Meanwhile, the decoder 142 may output "0"s to turn off the AND gates 7-2, ..., 7-N, so that the scan chains 11-2, ..., 11-N continuously receive "0"s. Because logic values of the scan chains 11-2, ..., 11-N do not change, a sequential logic gate in the chip does not operate. Because the sequential logic gate does not operate, power consumption in a test process can be reduced. The mask controller 15 includes a mask register 151 and a mask decoder 152. The mask decoder 152 generates a control signal through decoding to control one or more of the AND gates 9-1, 9-2, ..., 9-N to be turned on or off. Similarly, the mask decoder 152 may generate a control signal through decoding to disable an AND gate that is in the AND gates 9-1, 9-2, ..., 9-N and that corresponds to a scan chain having an X state.

It should be understood that a structure of the decompression module 12 is not limited in embodiments of this application. The decompression module 12 may be any circuit capable of expanding a small amount of test excitation to a large quantity of test patterns of a scan chain and outputting the test patterns. The decompression module 12 may be, for example, a random signal generator. Similarly, a structure of the compression module 13 is not limited in embodiments of this application. The compression module 13 may be any circuit capable of receiving a test response and performing a logical operation on the received test response to output a compressed test response through a few output channels. The compression module 13 may be, for example, a compression module based on a multiple-input signature register (multiple-input signature register, MISR) or an XOR gate (XOR) tree structure.

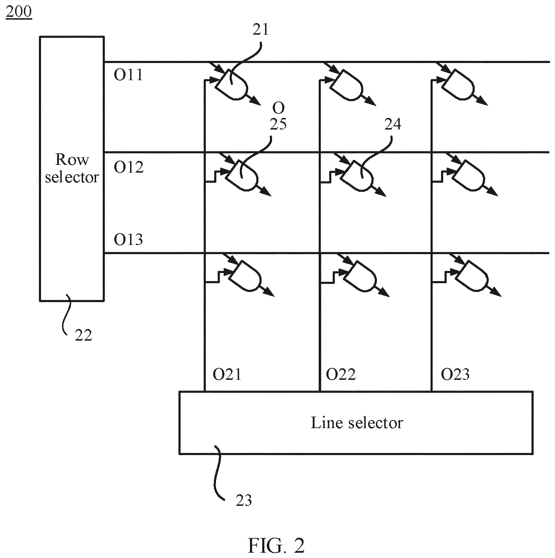

FIG. 2 is a schematic diagram of a two-dimensional switch matrix circuit 200 used in a low-power decoder 142 or a mask decoder 152 according to some embodiments of this disclosure. The two-dimensional switch matrix circuit 200 includes a plurality of rows and a plurality of columns. Each row may be controlled by a corresponding row selection signal (a row encoded bit, row encoded bit) of a row selector 22. Each column may be controlled by a corresponding column selection signal (a column encoded bit, column encoded bit) of a column selector 23. In FIG. 2, lines of the row and the column are not directly coupled, but are coupled through a switch. The two-dimensional switch matrix circuit 200 has, at each node in the row and the column, a switch, such as a switch 21, 24, or 25, coupled to a scan chain of a to-be-tested circuit 11, where the switch is for enabling. In an embodiment, a switch in a decoder may be an AND gate or an OR gate. For example, in an embodiment, an AND gate may be used as a switch for the low-power decoder 142, and an OR gate may be used as a switch for the mask decoder 152. This is not limited in this disclosure. When the AND gate is used as the switch 21, if both the row selection signal and the column selection signal are 1, a control bit signal output by the switch is 1, in other words, the switch is to enable an AND gate 7 or 9 coupled to a corresponding scan chain; or if the row selection signal or the column selection signal is 0, a control bit signal output by the switch is 0, in other words, the switch is to disable an AND gate 7 or 9 coupled to a corresponding scan chain.

A quantity of rows and a quantity of columns in the two-dimensional switch matrix circuit 200 may be related to a quantity N of scan chains of the to-be-tested circuit 11. For example, the N scan chains may be divided into n groups, each group includes m scan chains, and n×m is approximately equal to N. In this way, the two-dimensional switch matrix circuit 200 may be set as having m rows and n columns, each group (column) of scan chains is controlled by one column selection signal, and each row is controlled by one row selection signal. In addition, switches coupled to different scan chains may be distributed randomly or arranged according to a specific rule in the two-dimensional switch matrix circuit 200. In some embodiments, the scan chain controlled by the switch that is at each node may be random. In other words, a plurality of mapping relationships between a switch and a scan chain may be established. In this manner, the two-dimensional switch matrix circuit 200 may reuse a group encoded bit and a chain encoded bit, thereby increasing an encoding success rate.

Although FIG. 2 shows a case in which a plurality of switches are disposed at nodes at crosses of all rows and columns of a switch network, this is merely an example and is not intended to limit the scope of this disclosure. It may be understood that, when a quantity of scan chains is less than a total quantity of nodes in the switch network, no switches may be disposed on some nodes to further reduce costs. For example, when the to-be-tested circuit has 13 scan chains, a 4×4 two-dimensional switch network may be set, and three of 16 nodes are empty, in other words, no switches are disposed at the three nodes. In some other embodiments of this disclosure, a two-dimensional switch network with sparse switch distribution may be set.

In an actual test process, decompressed data is shifted and input to a plurality of scan chains 11-2, ..., 11-N based on a clock periodicity. However, at each clock periodicity, not all scan chains have a decompressed input. Due to an encoding limitation, when some scan chains each are enabled to receive a shift input, other scan chains that are not expected to be enabled may be enabled, which may cause an increase in power consumption and a decrease in an encoding success rate. For example, when the switches 21 and 24 are expected to be turned on, outputs O11 and 012 of the row selector 22 are set to 1, and an output 013 of the row selector 22 is set to 0. Similarly, outputs 021 and O22 of the column selector 23 are set to 1, and an output O23 is set to 0. It can be learned that both two inputs of the switch 25 are set to 1, and therefore, a scan chain corresponding to the switch 25 is enabled and receives a shift input. However, turn-on of the scan chain corresponding to the switch 25 increases test power consumption, and consequently, is not expected to be turned on in this case. When a plurality of scan chains that are enabled by mistake receive a plurality of shift inputs, increased power consumption may even burn a chip. Therefore, in consideration of power consumption control, a low-power controller 14 needs to control, based on a power consumption requirement, a quantity of scan chains that are simultaneously enabled. In addition, frequency at which all scan chains are enabled during testing may be different. Therefore, distribution, on the two-dimensional switch matrix, of the switches corresponding to the scan chains is expected to be optimized.

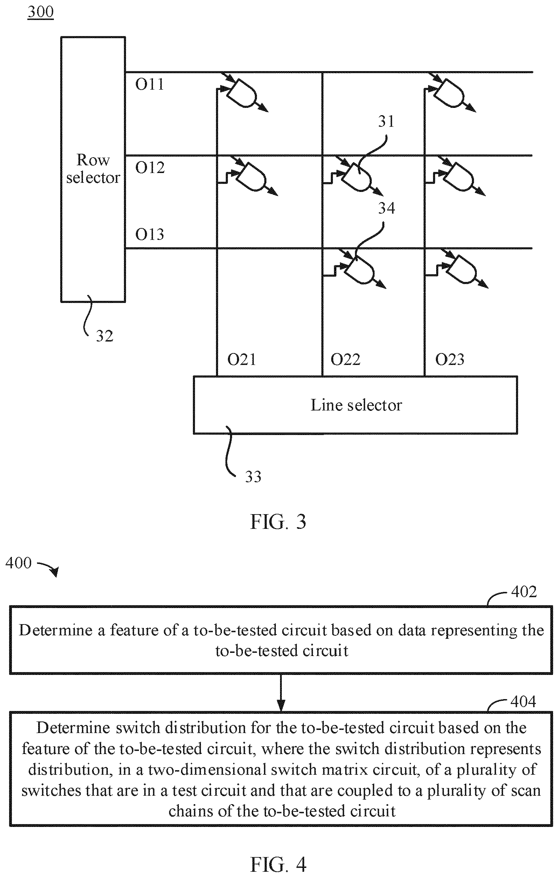

FIG. 3 is a schematic diagram of a sparse two-dimensional switch matrix circuit 300 used in a low-power decoder 142 or a mask decoder 152 according to some embodiments of this disclosure. The sparse two-dimensional switch matrix circuit 300 may be, for example, a specific implementation of the low-power decoder 142 or the mask decoder 152. It may be understood that, based on different to-be-tested circuits 11, the sparse two-dimensional switch matrix circuit may have different switch distribution. As shown in FIG. 3, the sparse two-dimensional switch matrix circuit 300 includes a plurality of rows and a plurality of columns. Each row may be controlled by a corresponding row selection signal of a row selector 32. Each column may be controlled by a corresponding column selection signal of a column selector 33. Different from a switch matrix circuit 200, the sparse two-dimensional switch matrix circuit 300 has, at only a part of nodes in the rows and the columns, a switch that is coupled to a scan chain of the to-be-tested circuit 11, for example, a switch 31 or 34. In other words, a switch coupled to a scan chain may not be disposed at a part of nodes in the rows and the columns of the sparse two-dimensional switch matrix circuit 300. Therefore, the sparse two-dimensional switch matrix circuit represents a two-dimensional switch matrix circuit in which at least one of the nodes does not have a switch. In FIG. 3, although crosses of rows and columns are shown at some nodes without switches, this is only for the purpose of simplifying the illustration. It may be understood that conductive wires of the row and the column are not coupled, but are disconnected at the node.

In the sparse two-dimensional switch matrix circuit 300, a quantity (control granularity of each dimension) of scan chains connected by each column encoded bit and a quantity of scan chains connected by each row encoded bit are allowed to be flexibly adjusted. For example, the quantity of scan chains connected by each row encoded bit may be less than a quantity n of columns, and the quantity of scan chains connected by each column encoded bit may be less than a quantity m of rows. In this specification, a granularity represents a quantity of switches controlled in a row or column. In some embodiments, a granularity of the sparse two-dimensional switch matrix circuit may be set as an even granularity. To be specific, each row and each column have switches with a substantially identical quantity, and a maximum difference between quantities of controlled switches is 1. Because each row and each column have the switches with the substantially identical or similar quantity, this may minimize a total quantity of switches that are turned on by mistake. For example, for comparison, the switch 34 is located at a node above the switch 31. In this case, if the switch 34 is turned on, turn-on of two switches on the left and right sides and the switch 31 (three switches in total) is affected. This is because when the switch 34 is turned on, a row and a column in which the switch 34 is located both need to be set to 1. In other words, in this case, encoding success rates of the three switches are affected. When the switch 34 is located in the position shown in FIG. 3, the switch 34 affects only the switch on the right side of the switch 34 and the switch 31 (only two switches). In other words, in this case, encoding success rates of the only two switches are affected. Therefore, setting the sparse two-dimensional switch matrix circuit 300 as a coefficient matrix with the even granularity can improve an encoding success rate. Although a $3 \times 3$ sparse two-dimensional switch matrix circuit 300 is shown in FIG. 3, this is merely an example and does not limit the scope of this disclosure. In some embodiments, the sparse two-dimensional switch matrix circuit may have a two-dimensional structure of $n \times m$, where n represents a quantity of rows and has an integer value greater than 1, m represents a quantity of columns and has an integer value greater than 1, and m and n may be the same or different.

Similar to the switch in FIG. 2, the switch in FIG. 3 may be an AND gate. In some other embodiments, the switch may be another logic gate or another switch. For example, for an encoding decoder, an OR gate may be used as a switch. If both the row selection signal and the column selection signal are 1, a control bit signal output by the switch is 1, in other words, the switch is to enable a corresponding scan chain. If the row selection signal or the column selection signal is 0, a control bit signal output by the switch 31 is 0, in other words, the switch is to disable a corresponding scan chain. A quantity of rows and a quantity of columns in the sparse two-dimensional switch matrix circuit 300 may be related to a quantity of scan chains of the to-be-tested circuit 11. Switches coupled to different scan chains may be distributed randomly or arranged according to a specific rule in the sparse two-dimensional switch matrix circuit 300. In some embodiments of this disclosure, optimized two-dimensional sparse switch distribution for the to-be-tested circuit 11 may be obtained through ATPG learning, as described below.

FIG. 4 is a schematic flowchart of a method 400 for determining switch distribution for a to-be-tested circuit 11 according to some embodiments of this disclosure. The method 400 is for determining the switch distribution for the to-be-tested circuit 11. For example, the method 400 may be for determining switch distribution in a sparse two-dimensional switch matrix circuit used in a low-power decoder 142. The method 400 may further be for determining switch distribution in a sparse two-dimensional switch matrix circuit used in a mask decoder 152. The method 400 may be performed by an electronic device with a computing capability, for example, a computer. After optimized switch distribution is obtained, a sparse two-dimensional switch matrix circuit with the optimized switch distribution may be integrated into a design of a chip including the to-be-tested circuit 11 for actual chip manufacturing.

In 402, a feature of the to-be-tested circuit 11 is determined based on data representing the to-be-tested circuit 11. In some embodiments, the data representing the to-be-tested circuit 11 may include a netlist file of the to-be-tested circuit 11. The feature of the to-be-tested circuit 11 may include use distribution of a plurality of scan chains of the to-be-tested circuit 11 in each clock periodicity during a test period and distribution of an X state in each clock periodicity during the test period. For example, the feature of the to-be-tested circuit 11 may indicate scan chains that are in the plurality of scan chains and that are used in an $a^{th}$ clock periodicity and scan chains that are in the plurality of scan chains and that output X states, where a is an integer greater than 0. In some other embodiments, the feature of the to-be-tested circuit 11 may further include use frequency of the scan chains, use correlation of the scan chains, and the like. The use correlation of the scan chain indicates a probability that each scan chain is used together with another scan chain. Specifically, a netlist file representing the to-be-tested circuit 11 may be used to perform sampling on a plurality of faults and perform ATPG, so as to obtain a test pattern. The test pattern includes a plurality of test packets for the plurality of faults. One test packet is used for one corresponding fault. Then, the electronic device may obtain the feature of the to-be-tested circuit 11 based on the test pattern.

In some other embodiments, the feature of the to-be-tested circuit 11 may be unknown state distribution of the to-be-tested circuit 11. The unknown state distribution may include static distribution and dynamic distribution. The unknown state distribution of the to-be-tested circuit 11 may be determined based on a netlist file that describes the to-be-tested circuit 11. Specifically, static analysis may be performed on the netlist file to determine static unknown state distribution . Alternatively or additionally, dynamic unknown state distribution may be determined by performing, on the to-be-tested circuit 11, loading of a random filled pattern (random filled pattern), loading of a design constraint (for example, synopsis design constraint), circuit simulation, and unloading (unloading) of a simulation result.

In 404, the switch distribution for the to-be-tested circuit 11 is determined based on the feature of the to-be-tested circuit 11. The switch distribution represents distribution, in the two-dimensional switch matrix circuit, of a plurality of switches that are in a test circuit and that are coupled to the plurality of scan chains of the to-be-tested circuit 11. In an embodiment, the test circuit may be, for example, a circuit module that is configured to test the to-be-tested circuit and that is in a chip, for example, the decoder 142 or 152, or a switch matrix circuit 200 or 300. The two-dimensional switch matrix circuit includes a plurality of rows and a plurality of columns, any one of the plurality of rows has at least one of the plurality of switches, and any one of the plurality of columns has at least one of the plurality of switches. The determining the switch distribution includes determining a quantity of rows and a quantity of columns of the two-dimensional switch matrix circuit. The determining the switch distribution further includes determining distribution, at nodes in the two-dimensional switch matrix circuit, of the plurality of switches coupled to the scan chains.

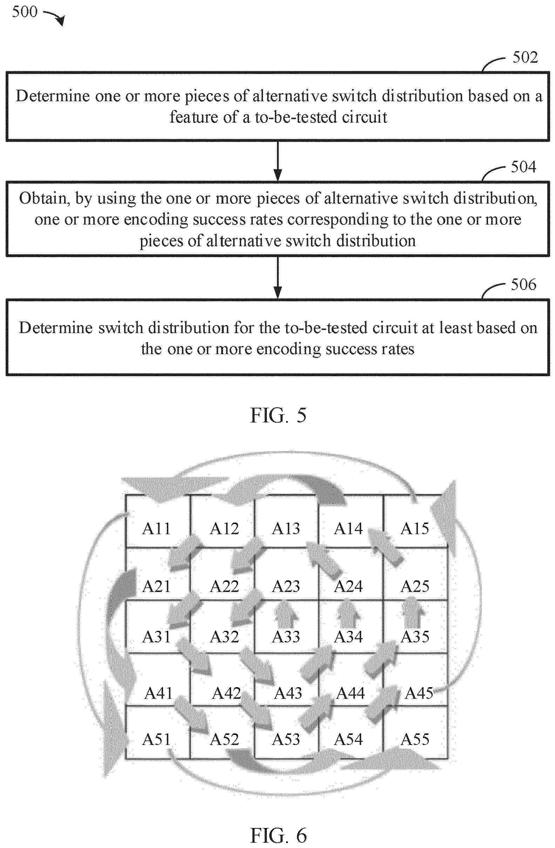

In some embodiments, the switch distribution may be determined by using a random policy or a deterministic policy, as described in detail below. FIG. 5 is a schematic flowchart of a method 500 for determining switch distribution according to some embodiments of this disclosure. In 502, one or more pieces of alternative switch distribution may be determined based on a feature of a to-be-tested circuit 11. It may be understood that, for a specific requirement, there may be a plurality of pieces of distribution of a two-dimensional switch matrix circuit.

For the two-dimensional switch matrix circuit, a quantity of corresponding scan chains is determined, for example, may be determined in step 402. For example, a total quantity of scan chains is N, where N represents an integer greater than 1. In an embodiment, the determining the alternative switch distribution includes determining a quantity of rows and a quantity of columns of the two-dimensional switch matrix circuit. The determining the alternative switch distribution further includes determining distribution, at nodes in the two-dimensional switch matrix circuit, of a plurality of switches coupled to scan chains. An initial sparsity may be obtained based on the feature of the to-be-tested circuit 11. The quantity of rows and the quantity of columns of the switch distribution may be calculated by using the initial sparsity. A sparsity may be defined as $\left(\sqrt{\frac{nm}{N}} - 1\right) \times 100\%$, where m and n are quantities of rows and columns of the two-dimensional switch matrix circuit, and $N$ is the quantity of scan chains of the to-be-tested circuit 11. For example, the initial sparsity may be determined based on an encoding success rate estimation model. The initial sparsity may be determined by using a binary search algorithm with reference to formulas (1) to (3).

$$f^s(m_1, n_1, k) = \binom{m_0(1+s)}{m_1}\binom{n_0(1+s)}{n_1}\left[\binom{\frac{m_1 n_1}{(1+s)^2}}{k} - \sum_{u+v=2}^{m_1+n_1-1} f^{m_1,n_1}(u,v,k)\right] \quad (1)$$

$$S^s(k, \alpha) = \frac{1}{\binom{N}{k}} \sum_{m_1 n_1 < N(1+s)^2 \cdot \alpha} \left\{\binom{m_0(1+s)}{m_1}\binom{n_0(1+s)}{n_1}\left[\binom{\frac{m_1 n_1}{(1+s)^2}}{k} - \sum_{u+v=2}^{m_1+n_1-1} f^{m_1,n_1}(u,v,k)\right]\right\} \quad (2)$$

$$P^s(\alpha) = \sum_{k=0}^{N} d_k \cdot S^s(k, \alpha) \quad (3)$$

$N$ represents the total quantity of scan chains, $s$ represents a sparsity, $P$ represents an encoding success rate, $k$ represents that a test packet uses $k$ scan chains, $d_k$ represents a proportion of test packets each of which uses $k$ scan chains and that are in a test packet set collected by an ATPG, and $\alpha$ represents a maximum value, expected by a user, of a proportion of scan chains enabled after encoding and decoding, where $\alpha$ may also be referred to as a low-power threshold. $m_0$ and $n_0$ represent a quantity of rows and a quantity of columns obtained by closely arranging the $N$ scan chains into a square matrix, that is, $m_0 \times n_0 = N$. $f^s(m_1, n_1, k)$ represents a combination number of $k$ scan chains that are successfully encoded in an $m_1 \times n_1$ submatrix of switch distribution when the sparsity is s. $m_1$ and $n_1$ indicate that the $k$ enabled scan chains may be distributed in $m_1$ rows and $n_1$ columns of the sparse two-dimensional switch matrix circuit. $u$ and $v$ indicate that the $k$ enabled scan chains may be distributed in a $u^{th}$ row and a $v^{th}$ column in the $m_1$ rows and the $n_1$ columns in the sparse two-dimensional switch matrix circuit. $S^s(\alpha)$ indicates a success rate of successfully encoding the $k$ scan chains when the sparsity is $s$ and $\alpha$ is given. A weighted sum of the success rate $S^s(\alpha)$ and $d_k$ represents an encoding success rate $P^s(\alpha)$, of the test packet set collected by the ATPG, corresponding to the sparse two-dimensional switch matrix circuit determined by the current sparsity $s$.

When the encoding success rate $P^s(\alpha)$ is greater than a maximum encoding success rate $P_{max}$, the sparsity $s$ may be used as an initial sparsity $s_0$. A higher sparsity indicates higher hardware costs. In addition, it is found through research that when the sparsity reaches a specific value, the encoding success rate does not increase significantly. Therefore, a condition that the initial sparsity $s_0$ needs to be less than a maximum sparsity $s_{max}$ may be further set.

The maximum encoding success rate $P_{max}$ may be adjustable. For example, $P_{max}$ may be set to 99%. The maximum sparsity $s_{max}$ is also adjustable. For example, $s_{max}$ may be set to 100%. The maximum sparsity $s_{max}$ may be related to a switch power (switch power) limitation. The switch power limitation indicates a ratio of a quantity of actually flipped registers on a scan chain during shift input to a maximum quantity of flipped registers.

Based on the determined sparsity $s$, the quantity m of rows and the quantity n of columns in the two-dimensional switch matrix circuit may be determined with reference to formulas (4) and (5).

$$n = \lceil \sqrt{N} \rceil \left(1 + \frac{s}{100}\right) \quad (4)$$

$$m = \lfloor \sqrt{N} \rfloor \left(1 + \frac{s}{100}\right) \quad (5)$$

The one or more pieces of alternative switch distribution may be determined at an even granularity based on the determined quantity m of rows and the determined quantity n of columns by using a random policy or a deterministic policy. The even granularity indicates that a difference between quantities of switches in any two of the m rows is the smallest, and a difference between quantities of switches in any two of the n columns is the smallest. In other words, based on the determined quantity m of rows and the determined quantity n of columns, the distribution, at the nodes, of the switches coupled to the N scan chains may be determined. The switches may be randomly distributed or arranged according to a deterministic rule. Details of the random policy and the deterministic policy are described in detail below with reference to FIG. 6.

In 504, one or more encoding success rates corresponding to the one or more pieces of alternative switch distribution may be obtained by using the one or more pieces of alternative switch distribution. For example, the one or more encoding success rates corresponding to the one or more pieces of alternative switch distribution may be validated for a test set. After distribution of the plurality of switches in the two-dimensional switch matrix circuit is determined, an encoding success rate may be calculated for each determined alternative switch distribution. The electronic device may determine the test set based on the test packet set collected by the ATPG. In some embodiments, for the low-power decoder 142, the test set may be a test packet set determined by the ATPG through fault sampling, and the test set may store only an identifier of a scan chain. In some embodiments, for the mask decoder 152, the test set may include two parts: an observation test set and a mask test set. The observation test set includes an identifier of a scan chain on which a value of a logic gate to be observed is located, and the value of the logic gate to be observed is a value of a logic gate corresponding to a test packet. The mask test set includes an identifier of a scan chain on which an X state that prevents the value of the logic gate from being observed is located. The one or more pieces of alternative switch distribution are validated for the test set, to obtain the corresponding encoding success rate or rates.

In 506, switch distribution for the to-be-tested circuit 11 may be determined at least based on the one or more encoding success rates. In an embodiment, the switch distribution may be determined based on the encoding success rate. Additionally, the switch distribution may be determined based on both the encoding success rate and the sparsity. For example, it may be determined whether the encoding success rate reaches an encoding success rate threshold. The encoding success rate threshold may be the maximum encoding success rate $P_{max}$. If the encoding success rate threshold is reached, current switch distribution may be determined as the switch distribution for the to-be-tested circuit 11. Alternatively or additionally, the one or more encoding success rates may be compared with the encoding success rate threshold to determine a first alternative switch distribution set. Each alternative switch distribution in the first alternative switch distribution set has an encoding success rate higher than the encoding success rate threshold. Further, alternative switch distribution that is in the first alternative switch distribution set and that has a minimum sparsity may be determined as the switch distribution for the to-be-tested circuit 11.

Alternatively, if the encoding success rate does not reach the encoding success rate threshold but the sparsity reaches a sparsity threshold, the current switch distribution may be determined as the switch distribution for the to-be-tested circuit 11. Alternatively, if the encoding success rate does not reach the encoding success rate threshold and the sparsity does not reach an sparsity threshold, the sparsity may be increased. Based on an increased sparsity, one or more pieces of new alternative switch distribution may be determined, and steps 504 and 506 are repeated, so as to determine the switch distribution for the to-be-tested circuit 11.

In some embodiments, the method 500 above may be used to determine the corresponding switch distribution by using the random policy and the deterministic (deterministic) policy. In other words, the random policy may be used to determine first switch distribution that meets a threshold condition. The deterministic policy may also be used to determine second switch distribution that meets the threshold condition. Final switch distribution may be further determined by comparing at least one of the following: encoding success rates and sparsities of the first switch distribution and the second switch distribution. For example, if a difference between an encoding success rate of the first switch distribution and an encoding success rate of the second switch distribution for the test set is greater than a threshold $\delta$, switch distribution with a higher encoding success rate is selected as the final switch distribution. By contrast, if the difference between the encoding success rates is less than the threshold $\delta$, switch distribution with a smaller sparsity, namely, switch distribution with fewer encoded bits, is selected as the final switch distribution.

Details of the random policy and the deterministic policy are described in detail below. As described above, the one or more pieces of alternative switch distribution may be determined at the even granularity based on the determined quantity m of rows and the determined quantity n of columns by using the random policy or the deterministic policy. For example, N switches coupled to the N scan chains may be disposed at a plurality of nodes in the two-dimensional switch matrix circuit by using the random policy or the deterministic policy. The plurality of nodes may be some nodes in the rows and the columns of the two-dimensional switch matrix circuit. A plurality of nodes at which switches are to be disposed and that are in the two-dimensional switch matrix circuit may be determined at the even granularity based on the quantity m of rows and the quantity n of columns by using the random policy or the deterministic policy.

In some embodiments, based on the determined plurality of nodes, the plurality of switches may be disposed at the plurality of nodes in a random manner to determine the one or more pieces of alternative switch distribution. In an embodiment, each switch coupled to a corresponding scan chain may be randomly arranged at one of the plurality of nodes. In another embodiment, the plurality of switches may alternatively be disposed at the plurality of nodes in a deterministic manner to determine the one or more pieces of alternative switch distribution. In other words, each switch coupled to a corresponding scan chain may be arranged at one of the plurality of nodes according to a rule. For the low-power decoder, the rule may be related to use frequency and use correlation of the scan chain. For the mask decoder, the rule may be related to unknown state distribution of the scan chain.

In some embodiments, the plurality of switches may be disposed at the plurality of nodes in a spiral manner from a center to a periphery based on use frequency of corresponding scan chains, so as to determine the one or more pieces of alternative switch distribution. A switch that is in the plurality of switches and that corresponds to a scan chain, with highest use frequency, in the plurality of scan chains is disposed at a central node in the plurality of nodes. Specifically, spiral winding may be performed on the scan chains from the center to the periphery in descending order of activation probabilities of the scan chains determined based on the test packet set.

Alternatively or additionally, for the mask decoder, a scan chain that does not include an X state may be arranged on the periphery, and then spiral winding is performed on the scan chains from the center to the periphery in a descending order of frequency of X states in the scan chains. In other words, a switch coupled to the scan chain that does not include the X state is distributed on the periphery of the two-dimensional switch matrix circuit, and a switch coupled to a scan chain that has highest X-state frequency is distributed on a node at the center of the two-dimensional switch matrix circuit.

Alternatively or additionally, the plurality of switches may be disposed at the plurality of nodes in a spiral manner from a center to a periphery based on use correlation of the corresponding scan chains, so as to determine the one or more pieces of alternative switch distribution. Use correlation of scan chains corresponding to two switches that are adjacent in a first direction or a second direction and that are in the plurality of switches is greater than use correlation of scan chains corresponding to two other switches that are not adjacent in the first direction or the second direction and that are in the plurality of switches. The use correlation of the scan chain may refer to a probability that each scan chain is used together with another scan chain.

FIG. 6 is a schematic diagram of spiral winding determined based on use correlation of scan chains according to some embodiments of this disclosure. A spiral winding manner in FIG. 6 is applicable to the switch distribution in FIG. 2 or FIG. 3. In FIG. 6, each node in a two-dimensional switch matrix circuit is represented by a corresponding number. For example, numbers of nodes in the first row are A11, A12, A13, A14, and A15. FIG. 6 shows hierarchical spiral winding shown by arrows. For example, a node A33 located in a center may be spiral winding with a spiral hierarchy 0. A23→A32→A43→A34 may be spiral winding with a spiral hierarchy 1. A24→A13→A22→A31→A42→A53→A44→A35 may be spiral winding with a spiral hierarchy 2. According to this rule, A15→A11 →A51→A55 is spiral winding with a spiral hierarchy 4.

Based on the hierarchical spiral winding shown in FIG. 6, distribution, at a plurality of nodes in the nodes, of switches coupled to scan chains may be determined. Specifically, the scan chains may be sorted into a descending queue in a descending order of use frequency. The switches corresponding to the scan chains may be placed at corresponding nodes in ascending order of spiral hierarchies, so that use frequency of scan chains in a same spiral hierarchy is approximately equal. Because a scan chain is in one-to-one correspondence with a switch, for ease of description, "a scan chain is placed" is used below to indicate that a switch corresponding to the scan chain is placed, and the switch is coupled to the corresponding scan chain. Further, a newly placed scan chain of each node may be determined based on scan chains already placed at adjacent nodes, so that use correlation of the adjacent scan chains is maximum. For example, a scan chain that is to be placed at the A15 node may be determined to maximize use correlation between the scan chain placed at the A15 node and scan chains that are already placed in a submatrix ($3\times3$) formed by the central node A33 and the first row and the fifth column in which the scan chain is located. Use correlation between scan chains in a submatrix may be a weighted sum of use correlation between every two scan chains. The use correlation between the scan chains in the submatrix may alternatively be determined in another appropriate manner.

In this manner, scan chains additionally enabled by a low-power decoder 142 after encoding-decoding may be further reduced, and scan chains additionally disabled by a mask decoder 152 may be further reduced, thereby increasing an encoding success rate while reducing a quantity of encoded bits. In particular, this spiral winding manner may be used when a sparsity is large, thereby reducing power consumption and improving the encoding success rate.

According to the foregoing method, switch distribution applied to the low-power decoder 142 and the mask decoder 152 may be determined. Based on the determined switch distribution, circuit structures of the low-power decoder 142 and the mask decoder 152 may be determined. A new netlist file may be determined or an original netlist file may be updated, based on the circuit structures of the low-power decoder 142 and the mask decoder 152. These netlist files may be combined with other netlist files to form an ATPG test pattern used for an actual test.

According to the solutions in embodiments of this disclosure, a quantity of scan chains controlled by each encoded bit can be variable, and a quantity of scan chains controlled by each encoded bit may be flexibly adjusted based on an encoding capability requirement. Moreover,

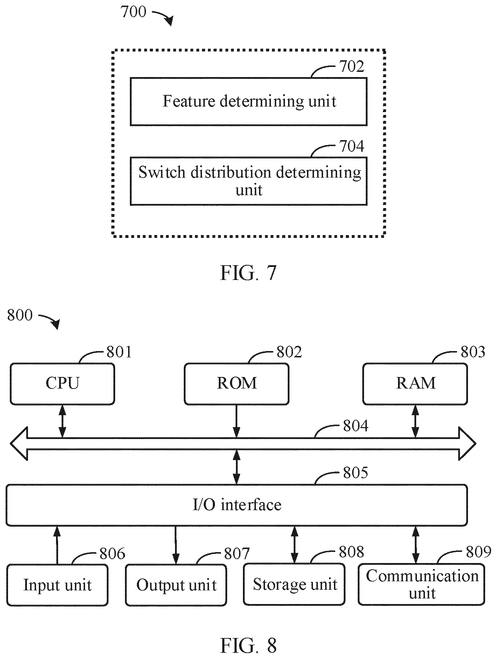

FIG. 7 is a schematic block diagram of an electronic device 700 according to some embodiments of this disclosure. The electronic device 700 may include a plurality of modules, configured to perform corresponding steps in the method 400 discussed in FIG. 4. As shown in FIG. 7, the electronic device 700 includes a feature determining unit 702, configured to determine a feature of a to-be-tested circuit 11 based on netlist data representing the to-be-tested circuit 11. The to-be-tested circuit is designed to be coupled to a test circuit in a chip, and the feature of the to-be-tested circuit includes at least one of scan chain distribution or unknown state distribution of the to-be-tested circuit. The electronic device 700 further includes a switch distribution determining unit 704, configured to determine switch distribution for the to-be-tested circuit based on the feature of the to-be-tested circuit, where the switch distribution represents distribution, in a two-dimensional switch matrix circuit, of a plurality of switches that are in the test circuit and that are coupled to a plurality of scan chains of the to-be-tested circuit. The two-dimensional switch matrix circuit includes a plurality of rows and a plurality of columns, any one of the plurality of rows has at least one of the plurality of switches, any one of the plurality of columns has at least one of the plurality of switches, and the plurality of switches are selectively turned on or off based on logical levels of the plurality of rows and the plurality of columns.

In some embodiments, the switch distribution determining unit 704 is further configured to: determine one or more pieces of alternative switch distribution based on the feature of the to-be-tested circuit 11; obtain, by using the one or more pieces of alternative switch distribution, one or more encoding success rates corresponding to the one or more pieces of alternative switch distribution; and select the switch distribution for the to-be-tested circuit 11 from the one or more pieces of alternative switch distribution at least based on the one or more encoding success rates.

In some embodiments, the switch distribution determining unit 704 is further configured to: obtain an initial sparsity based on the feature of the to-be-tested circuit 11, and calculate a quantity of rows and a quantity of columns of the switch distribution by using the initial sparsity; and determine the one or more pieces of alternative switch distribution at an even granularity based on the quantity of rows and the quantity of columns, where the even granularity indicates that a difference between quantities of switches in any two of the plurality of rows is not greater than 1, and a difference between quantities of switches in any two of the plurality of columns is not greater than 1. The initial sparsity represents an initial sparsity degree of the plurality of switches relative to all nodes in the rows and the columns of the two-dimensional switch matrix circuit.

In some embodiments, the switch distribution determining unit 704 is further configured to: determine, at the even granularity based on the quantity of rows and the quantity of columns, a plurality of nodes at which switches are to be disposed and that are in the two-dimensional switch matrix circuit; and dispose the plurality of switches at the plurality of nodes in a random manner to determine the one or more pieces of alternative switch distribution.

In some embodiments, the switch distribution determining unit 704 is further configured to: determine, at the even granularity based on the quantity of rows and the quantity of columns, a plurality of nodes at which switches are to be disposed and that are in the two-dimensional switch matrix circuit; and dispose, at the plurality of nodes in a spiral manner from a center to a periphery based on use frequency of the plurality of scan chains, the plurality of switches corresponding to the plurality of scan chains, so as to determine the one or more pieces of alternative switch distribution, where a switch that is in the plurality of switches and that corresponds to a scan chain, with highest use frequency, in the plurality of scan chains is disposed at a central node in the plurality of nodes.

In some embodiments, the switch distribution determining unit 704 is further configured to: determine, at the even granularity based on the quantity of rows and the quantity of columns, a plurality of nodes at which switches are to be disposed and that are in the two-dimensional switch matrix circuit; and dispose, at the plurality of nodes in a spiral manner from a center to a periphery based on use correlation of the plurality of scan chains, the plurality of switches corresponding to the plurality of scan chains, so as to determine the one or more pieces of alternative switch distribution, where use correlation of scan chains corresponding to two switches that are adjacent in a first direction or a second direction and that are in the plurality of switches is greater than use correlation of scan chains corresponding to two other switches that are not adjacent in the first direction or the second direction and that are in the plurality of switches, and the first direction is perpendicular to the second direction.

In some embodiments, the switch distribution determining unit 704 is further configured to: compare the one or more encoding success rates with a success rate threshold to determine a first alternative switch distribution set, where each alternative switch distribution in the first alternative switch distribution set has an encoding success rate higher than the success rate threshold; and determine alternative switch distribution that is in the first alternative switch distribution set and that has a minimum sparsity as the switch distribution for the to-be-tested circuit 11.

In some embodiments, the feature determining unit 702 is further configured to determine the scan chain distribution of the to-be-tested circuit 11 based on a netlist file that describes the to-be-tested circuit 11.

In some embodiments, the feature determining unit 702 is further configured to: generate a test pattern based on the netlist file, and determine the scan chain distribution based on the test pattern.

In some embodiments, the feature determining unit 702 is further configured to determine the unknown state distribution of the to-be-tested circuit 11 based on a netlist file that describes the to-be-tested circuit 11.

FIG. 8 is a schematic block diagram of an example device 800 that may be used to implement embodiments of this disclosure. The device 800 may be configured to implement the foregoing electronic device 700. As shown in the figure, the device 800 includes a computing unit 801 that may perform various appropriate actions and processing based on computer program instructions stored in a random access memory (RAM) and/or a read-only memory (ROM) 802 or computer program instructions loaded from a storage unit 807 into the RAM and/or the ROM 802. The RAM and/or the ROM 802 may further store various programs and data required for an operation of the device 800. The computing unit 801 and the RAM and/or the ROM 802 are connected to each other through a bus 803. An input/output (I/O) interface 804 is also connected to the bus 803.

A plurality of components in the device 800 are connected to the I/O interface 804, and include: an input unit 805, for example, a keyboard or a mouse; an output unit 806, for example, a display or a loudspeaker of various types; a storage unit 807, for example, a magnetic disk or an optical disc; and a communication unit 808, for example, a network adapter, a modem, or a wireless communication transceiver. The communication unit 808 allows the device 800 to exchange information/data with another device through a computer network such as the Internet and/or various telecommunications networks.

The computing unit 801 may be various general-purpose and/or dedicated processing components that have processing and computing capabilities. Some examples of the computing unit 801 include but are not limited to a central processing unit (CPU), a graphics processing unit (GPU), various dedicated artificial intelligence (AI) computing chips, various computing units running machine learning model algorithms, a digital signal processor (DSP), and any appropriate processor, controller, microcontroller, and the like. The computing unit 801 performs the methods and processing described above, for example, the method 400 and/or the method 500. For example, in some embodiments, the method 400 and/or the method 500 may be implemented as a computer software program, which is tangibly included in a machine-readable medium, for example, the storage unit 807. In some embodiments, a part or all of the computer programs may be loaded into and/or installed on the device 800 via the RAM and/or the ROM and/or the communication unit 808. When the computer program is loaded into the RAM and/or the ROM and executed by the computing unit 801, one or more steps of the method 400 and/or the method 500 described above may be performed. Alternatively, in another embodiment, the computing unit 801 may be configured to perform the method 400 and/or the method 500 in any other appropriate manner (for example, through firmware).

A program code for implementing the method disclosed in this disclosure may be written in any combination of one or more programming languages. The program code may be provided for a processor or a controller of a general-purpose computer, a dedicated computer, or another programmable data processing apparatus, so that when the program code is executed by the processor or the controller, functions/operations specified in flowcharts and/or block diagrams are implemented. The program code may be completely executed on a machine, partially executed on the machine, partially executed on the machine as an independent software package, partially executed on a remote machine, or completely executed on the remote machine or a server.

In context of this disclosure, the machine-readable medium may be a tangible medium that may include or store programs for use by, or in combination with, an instruction execution system, an apparatus, or a device. The machine-readable medium may be a machine-readable signal medium or a machine-readable storage medium. The machine-readable medium may include but is not limited to an electronic, a magnetic, an optical, an electromagnetic, an infrared, or a semiconductor system, apparatus, or device, or any appropriate combination of the foregoing content. More detailed examples of the machine-readable storage medium include an electrical connection with one or more wires, a portable computer disk, a hard disk, a random access memory (RAM), a read-only memory (ROM), an erasable programmable read-only memory (EPROM or a flash memory), an optical fiber, a portable compact disc read-only memory (CD-ROM), an optical storage device, a magnetic storage device, or any suitable combination of the foregoing content.

Furthermore, while operations are depicted in a particular order, this should be understood as requiring these operations to be performed in the particular order shown or in a sequential order, or requiring all the illustrated operations to be performed to achieve a desired result. In specific circumstances, multitasking and parallel processing may be advantageous. Similarly, although several specific implementation details are included in the foregoing descriptions, these should not be construed as a limitation on the scope of this disclosure. Specific features described in context of separate embodiments may also be implemented in combination in a single implementation. Conversely, various features described in context of the single implementation may also be implemented in a plurality of implementations either individually or in any suitable sub-combination.

Although the subject matter has been described in language specific to structural features and/or methodological actions, it should be understood that the subject matter defined in the appended claims is not limited to the specific features or actions described above. On the contrary, the specific features and actions described above are merely example forms of implementing the claims.

## Claims

1. A method for designing a test circuit, comprising:

    determining a feature of a to-be-tested circuit based on netlist data representing the to-be-tested circuit, wherein the to-be-tested circuit is designed to be coupled to the test circuit in a chip, and the feature of the to-be-tested circuit comprises at least one of scan chain distribution or unknown state distribution of the to-be-tested circuit; and

    determining switch distribution for the to-be-tested circuit based on the feature of the to-be-tested circuit, wherein the switch distribution represents distribution, in a two-dimensional switch matrix circuit, of a plurality of switches that are in the test circuit and that are coupled to a plurality of scan chains of the to-be-tested circuit, the two-dimensional switch matrix circuit comprises a plurality of rows and a plurality of columns, any one of the plurality of rows has at least one of the plurality of switches, any one of the plurality of columns has at least one of the plurality of switches, and the plurality of switches are selectively turned on or off based on logical levels of the plurality of rows and the plurality of columns.

2. The method according to claim 1, wherein the determining switch distribution for the to-be-tested circuit based on the feature of the to-be-tested circuit comprises:

    determining one or more pieces of alternative switch distribution based on the feature of the to-be-tested circuit;
    obtaining, by using the one or more pieces of alternative switch distribution, one or more encoding success rates corresponding to the one or more pieces of alternative switch distribution; and
    selecting the switch distribution for the to-be-tested circuit from the one or more pieces of alternative switch distribution at least based on the one or more encoding success rates.

3. The method according to claim 2, wherein the determining one or more pieces of alternative switch distribution based on the feature of the to-be-tested circuit comprises:

    obtaining an initial sparsity based on the feature of the to-be-tested circuit, wherein the initial sparsity represents an initial sparsity degree of the plurality of switches relative to all nodes in the rows and the columns of the two-dimensional switch matrix circuit;
    calculating a quantity of rows and a quantity of columns of the switch distribution by using the initial sparsity; and
    determining the one or more pieces of alternative switch distribution at an even granularity based on the quantity of rows and the quantity of columns, wherein the even granularity indicates that a difference between quantities of switches in any two of the plurality of rows is not greater than 1, and a difference between quantities of switches in any two of the plurality of columns is not greater than 1.

4. The method according to claim 3, wherein the determining the one or more pieces of alternative switch distribution at an even granularity based on the quantity of rows and the quantity of columns comprises:

    determining, at the even granularity based on the quantity of rows and the quantity of columns, a plurality of nodes at which switches are to be disposed and that are in the two-dimensional switch matrix circuit; and
    disposing the plurality of switches at the plurality of nodes in a random manner to determine the one or more pieces of alternative switch distribution.

5. The method according to claim 3, wherein the determining the one or more pieces of alternative switch distribution at an even granularity based on the quantity of rows and the quantity of columns comprises:

    determining, at the even granularity based on the quantity of rows and the quantity of columns, a plurality of nodes at which switches are to be disposed and that are in the two-dimensional switch matrix circuit; and
    disposing, at the plurality of nodes in a spiral manner from a center to a periphery based on use frequency of the plurality of scan chains, the plurality of switches corresponding to the plurality of scan chains, so as to determine the one or more pieces of alternative switch distribution, wherein a switch that is in the plurality of switches and that corresponds to a scan chain, with highest use frequency, in the plurality of scan chains is disposed at a central node in the plurality of nodes.

6. The method according to claim 3, wherein the determining the one or more pieces of alternative switch distribution at an even granularity based on the quantity of rows and the quantity of columns comprises:

determining, at the even granularity based on the quantity of rows and the quantity of columns, a plurality of nodes at which switches are to be disposed and that are in the two-dimensional switch matrix circuit; and disposing, at the plurality of nodes in a spiral manner from a center to a periphery based on use correlation of the plurality of scan chains, the plurality of switches corresponding to the plurality of scan chains, so as to determine the one or more pieces of alternative switch distribution, wherein use correlation of scan chains corresponding to two switches that are adjacent in a first direction or a second direction and that are in the plurality of switches is greater than use correlation of scan chains corresponding to two other switches that are not adjacent in the first direction or the second direction and that are in the plurality of switches, and the first direction is perpendicular to the second direction.

7. The method according to any one of claims 2 to 6, wherein the determining the switch distribution for the to-be-tested circuit at least based on the one or more encoding success rates comprises:

comparing the one or more encoding success rates with a success rate threshold to determine a first alternative switch distribution set, wherein each alternative switch distribution in the first alternative switch distribution set has an encoding success rate higher than the success rate threshold; and determining alternative switch distribution that is in the first alternative switch distribution set and that has a minimum sparsity as the switch distribution for the to-be-tested circuit.

8. The method according to any one of claims 1 to 7, wherein the determining a feature of a to-be-tested circuit based on data representing the to-be-tested circuit comprises: determining the scan chain distribution of the to-be-tested circuit based on a netlist file that describes the to-be-tested circuit.

9. The method according to claim 8, wherein the determining the scan chain distribution of the to-be-tested circuit based on a netlist file comprises:

generating a test pattern based on the netlist file; and determining the scan chain distribution based on the test pattern.

10. The method according to any one of claims 1 to 7, wherein the determining a feature of a to-be-tested circuit based on netlist data representing the to-be-tested circuit comprises: determining the unknown state distribution of the to-be-tested circuit based on a netlist file that describes the to-be-tested circuit.

11. A computer-readable storage medium, storing a plurality of programs, wherein the plurality of programs are configured to be executed by one or more processors, and the plurality of programs comprise instructions for performing the method according to any one of claims 1 to 10.

12. A computer program product, wherein the computer program product comprises a plurality of programs, the plurality of programs are configured to be executed by one or more processors, and the plurality of programs comprise instructions for performing the method according to any one of claims 1 to 10.

13. An electronic device, comprising:

one or more processors; and a memory comprising computer instructions, wherein when the computer instructions are executed by the one or more processors of the electronic device, the electronic device is enabled to perform the method according to any one of claims 1 to 10.

14. An electronic device, comprising:

a feature determining unit, configured to determine a feature of a to-be-tested circuit based on netlist data representing the to-be-tested circuit, wherein the to-be-tested circuit is designed to be coupled to a test circuit in a chip, and the feature of the to-be-tested circuit comprises at least one of scan chain distribution or unknown state distribution of the to-be-tested circuit; and

a switch distribution determining unit, configured to determine switch distribution for the to-be-tested circuit based on the feature of the to-be-tested circuit, wherein the switch distribution represents distribution, in a two-dimensional switch matrix circuit, of a plurality of switches that are in the test circuit and that are coupled to a plurality of scan chains of the to-be-tested circuit, the two-dimensional switch matrix circuit comprises a plurality of rows and a plurality of columns, any one of the plurality of rows has at least one of the plurality of switches, any one of the plurality of columns has at least one of the plurality of switches, and the plurality of switches are selectively turned on or off based on logical levels of the plurality of rows and the plurality of columns.

15. The electronic device according to claim 14, wherein the switch distribution determining unit is further configured to: determine one or more pieces of alternative switch distribution based on the feature of the to-be-tested circuit;

obtain, by using the one or more pieces of alternative switch distribution, one or more encoding success rates corresponding to the one or more pieces of alternative switch distribution; and
select the switch distribution for the to-be-tested circuit from the one or more pieces of alternative switch distribution at least based on the one or more encoding success rates.

16. The electronic device according to claim 15, wherein the switch distribution determining unit is further configured to:

obtain an initial sparsity based on the feature of the to-be-tested circuit, wherein the initial sparsity represents an initial sparsity degree of the plurality of switches relative to all nodes in the rows and the columns of the two-dimensional switch matrix circuit;
calculate a quantity of rows and a quantity of columns of the switch distribution by using the initial sparsity; and
determine the one or more pieces of alternative switch distribution at an even granularity based on the quantity of rows and the quantity of columns, wherein the even granularity indicates that a difference between quantities of switches in any two of the plurality of rows is not greater than 1, and a difference between quantities of switches in any two of the plurality of columns is not greater than 1.

17. The electronic device according to claim 16, wherein the switch distribution determining unit is further configured to:

determine, at the even granularity based on the quantity of rows and the quantity of columns, a plurality of nodes at which switches are to be disposed and that are in the two-dimensional switch matrix circuit; and
dispose the plurality of switches at the plurality of nodes in a random manner to determine the one or more pieces of alternative switch distribution.

18. The electronic device according to claim 16, wherein the switch distribution determining unit is further configured to:

determine, at the even granularity based on the quantity of rows and the quantity of columns, a plurality of nodes at which switches are to be disposed and that are in the two-dimensional switch matrix circuit; and
dispose, at the plurality of nodes in a spiral manner from a center to a periphery based on use frequency of the plurality of scan chains, the plurality of switches corresponding to the plurality of scan chains, so as to determine the one or more pieces of alternative switch distribution, wherein a switch that is in the plurality of switches and that corresponds to a scan chain, with highest use frequency, in the plurality of scan chains is disposed at a central node in the plurality of nodes.

19. The electronic device according to claim 16, wherein the switch distribution determining unit is further configured to:

determine, at the even granularity based on the quantity of rows and the quantity of columns, a plurality of nodes at which switches are to be disposed and that are in the two-dimensional switch matrix circuit; and
dispose, at the plurality of nodes in a spiral manner from a center to a periphery based on use correlation of the plurality of scan chains, the plurality of switches corresponding to the plurality of scan chains, so as to determine the one or more pieces of alternative switch distribution, wherein use correlation of scan chains corresponding to two switches that are adjacent in a first direction or a second direction and that are in the plurality of switches is greater than use correlation of scan chains corresponding to two other switches that are not adjacent in the first direction or the second direction and that are in the plurality of switches, and the first direction is perpendicular to the second direction.

20. The electronic device according to any one of claims 15 to 19, wherein the switch distribution determining unit is further configured to:

compare the one or more encoding success rates with a success rate threshold to determine a first alternative switch distribution set, wherein each alternative switch distribution in the first alternative switch distribution set has an encoding success rate higher than the success rate threshold; and
determine alternative switch distribution that is in the first alternative switch distribution set and that has a minimum sparsity as the switch distribution for the to-be-tested circuit.

FIG. 1

FIG. 2

300

Row
selector

O11

O12

O13

31

34

32

O21    O22    O23

Line selector

33

FIG. 3

400

402

Determine a feature of a to-be-tested circuit based on data representing the
to-be-tested circuit

404

Determine switch distribution for the to-be-tested circuit based on the
feature of the to-be-tested circuit, where the switch distribution represents
distribution, in a two-dimensional switch matrix circuit, of a plurality of
switches that are in a test circuit and that are coupled to a plurality of scan
chains of the to-be-tested circuit

FIG. 4

500 ⌐

┌─────────────────────────────────────────────────────────────┐ ⌐ 502
│ Determine one or more pieces of alternative switch distribution based on a │
│ feature of a to-be-tested circuit │
└─────────────────────────────────────────────────────────────┘

│
▼

┌─────────────────────────────────────────────────────────────┐ ⌐ 504
│ Obtain, by using the one or more pieces of alternative switch distribution, │
│ one or more encoding success rates corresponding to the one or more │
│ pieces of alternative switch distribution │
└─────────────────────────────────────────────────────────────┘

│
▼

┌─────────────────────────────────────────────────────────────┐ ⌐ 506
│ Determine switch distribution for the to-be-tested circuit at least based on │
│ the one or more encoding success rates │
└─────────────────────────────────────────────────────────────┘

FIG. 5

FIG. 6

700

702

Feature determining unit

704

Switch distribution determining
unit

FIG. 7

800

801

CPU

802

ROM

803

RAM

804

805

I/O interface

806

Input unit

807

Output unit

808

Storage unit

809

Communication
unit

FIG. 8

### INTERNATIONAL SEARCH REPORT

| International application No. |
| --- |
| **PCT/CN2021/109508** |

**A. CLASSIFICATION OF SUBJECT MATTER**

G01R 31/3185(2006.01)i; G01R 31/28(2006.01)i

According to International Patent Classification (IPC) or to both national classification and IPC

**B. FIELDS SEARCHED**

Minimum documentation searched (classification system followed by classification symbols)

G01R

Documentation searched other than minimum documentation to the extent that such documents are included in the fields searched

Electronic data base consulted during the international search (name of data base and, where practicable, search terms used)

CNABS, CNTXT, WPABSC, ENTXTC, CNKI, 百度学术: 扫描链, 开关矩阵, 开关, 分布, 行, 列, 选择, 复用, X态, X状态, 未知值, 未知数, 未知态, 未知状态, 掩码, 掩膜, 掩模, 译码, 控制; VEN, WPABS, ENTXT, ISI, IEEE: scan chain, switch matrix, switch, distribution, row, select, multiplex, X, unknown, mask, decoding, control

**C. DOCUMENTS CONSIDERED TO BE RELEVANT**

| Category* | Citation of document, with indication, where appropriate, of the relevant passages | Relevant to claim No. |
| --- | --- | --- |
| A | CN 101405609 A (MENTOR GRAPHICS CORPORATION) 08 April 2009 (2009-04-08) description, pages 14-20, and figures 1-4 | 1-20 |
| A | CN 108627757 A (TOSHIBA CORPORATION) 09 October 2018 (2018-10-09) entire document | 1-20 |
| A | US 2005060625 A1 (WANG LAUNGTERNG et al.) 17 March 2005 (2005-03-17) entire document | 1-20 |
| A | US 2018120378 A1 (NATIONAL CHENG KUNG UNIVERSITY) 03 May 2018 (2018-05-03) entire document | 1-20 |
| A | US 10908213 B1 (SYNOPSYS INC.) 02 February 2021 (2021-02-02) entire document | 1-20 |
| A | US 5867507 A (IBM) 02 February 1999 (1999-02-02) entire document | 1-20 |
| A | US 7925947 B1 (SYNTEST TECHNOLOGIES INC.) 12 April 2011 (2011-04-12) entire document | 1-20 |

☑ Further documents are listed in the continuation of Box C.    ☑ See patent family annex.

| | |
| --- | --- |
| *   Special categories of cited documents: <br> "A"   document defining the general state of the art which is not considered to be of particular relevance <br> "E"   earlier application or patent but published on or after the international filing date <br> "L"   document which may throw doubts on priority claim(s) or which is cited to establish the publication date of another citation or other special reason (as specified) <br> "O"   document referring to an oral disclosure, use, exhibition or other means <br> "P"   document published prior to the international filing date but later than the priority date claimed | "T"   later document published after the international filing date or priority date and not in conflict with the application but cited to understand the principle or theory underlying the invention <br> "X"   document of particular relevance; the claimed invention cannot be considered novel or cannot be considered to involve an inventive step when the document is taken alone <br> "Y"   document of particular relevance; the claimed invention cannot be considered to involve an inventive step when the document is combined with one or more other such documents, such combination being obvious to a person skilled in the art <br> "&"   document member of the same patent family |

| Date of the actual completion of the international search | Date of mailing of the international search report |
| --- | --- |
| **18 April 2022** | **28 April 2022** |

| Name and mailing address of the ISA/CN | Authorized officer |
| --- | --- |
| **China National Intellectual Property Administration (ISA/CN)** <br> **No. 6, Xitucheng Road, Jimenqiao, Haidian District, Beijing 100088, China** | |
| Facsimile No. **(86-10)62019451** | Telephone No. |

Form PCT/ISA/210 (second sheet) (January 2015)

| | INTERNATIONAL SEARCH REPORT | International application No. |
| | | **PCT/CN2021/109508** |

**C.     DOCUMENTS CONSIDERED TO BE RELEVANT**

| Category* | Citation of document, with indication, where appropriate, of the relevant passages | Relevant to claim No. |
|---|---|---|
| A | US 2003101395 A1 (Albert Man et al.) 29 May 2003 (2003-05-29)<br>    entire document | 1-20 |
| A | US 2006101316 A1 (NEC LAB AMERICA INC.) 11 May 2006 (2006-05-11)<br>    entire document | 1-20 |
| A | US 2008256274 A1 (SYNOPSYS INC.) 16 October 2008 (2008-10-16)<br>    entire document | 1-20 |
| A | US 2005240848 A1 (LOGICVISION INC.) 27 October 2005 (2005-10-27)<br>    entire document | 1-20 |
| A | US 8533546 B1 (PMC-SIERRA US INC.) 10 September 2013 (2013-09-10)<br>    entire document | 1-20 |
| A | US 2004133831 A1 (Emrys Williams et al.) 08 July 2004 (2004-07-08)<br>    entire document | 1-20 |
| A | JP 2009092531 A (PANASONIC CORP.) 30 April 2009 (2009-04-30)<br>    entire document | 1-20 |
| A | Peter Wohl et al. "Scalable Selector Architecture for X-Tolerant Deterministic BIST."<br>*41st Design Automation Conference, 2004. Retrieved from<IEEE Explore Digital<br>Library, https://ieeexplore.ieee.org/stamp/stamp.jsp?tp=&arnumber=1322618><br><doi:10.1145/996566.996814>.,* 02 May 2005 (2005-05-02),<br>ISSN: 0738-100X,<br>    pages 934-939 | 1-20 |

Form PCT/ISA/210 (second sheet) (January 2015)

**INTERNATIONAL SEARCH REPORT**
Information on patent family members

International application No.

**PCT/CN2021/109508**

| Patent document cited in search report | | | Publication date (day/month/year) | Patent family member(s) | | | Publication date (day/month/year) |
|---|---|---|---|---|---|---|---|
| CN | 101405609 | A | 08 April 2009 | US | 2018156867 | A1 | 07 June 2018 |
| | | | | US | 2011231722 | A1 | 22 September 2011 |
| | | | | US | 2007234169 | A1 | 04 October 2007 |
| | | | | JP | 2009527737 | A | 30 July 2009 |
| | | | | US | 2015160290 | A1 | 11 June 2015 |
| | | | | JP | 2012154947 | A | 16 August 2012 |
| | | | | EP | 1994419 | A2 | 26 November 2008 |
| | | | | WO | 2007098167 | A2 | 30 August 2007 |
| | | | | CN | 102129031 | A | 20 July 2011 |
| | | | | US | 2016320450 | A1 | 03 November 2016 |
| | | | | US | 2007234157 | A1 | 04 October 2007 |
| | | | | US | 2013305107 | A1 | 14 November 2013 |
| | | | | EP | 2677328 | A1 | 25 December 2013 |
| | | | | US | 2007234163 | A1 | 04 October 2007 |
| | | | | US | 7818644 | B2 | 19 October 2010 |
| | | | | US | 7913137 | B2 | 22 March 2011 |
| | | | | CN | 101405609 | B | 14 November 2012 |
| | | | | US | 8418007 | B2 | 09 April 2013 |
| | | | | JP | 5268656 | B2 | 21 August 2013 |
| | | | | EP | 1994419 | B1 | 06 November 2013 |
| | | | | JP | 5554365 | B2 | 23 July 2014 |
| | | | | US | 8914694 | B2 | 16 December 2014 |
| | | | | CN | 102129031 | B | 11 March 2015 |
| | | | | EP | 2677328 | B1 | 29 July 2015 |
| | | | | US | 9250287 | B2 | 02 February 2016 |
| | | | | US | 9778316 | B2 | 03 October 2017 |
| | | | | US | 10120024 | B2 | 06 November 2018 |
| CN | 108627757 | A | 09 October 2018 | EP | 3379275 | A1 | 26 September 2018 |
| | | | | US | 2018275198 | A1 | 27 September 2018 |
| | | | | JP | 2018155707 | A | 04 October 2018 |
| | | | | US | 10401430 | B2 | 03 September 2019 |
| | | | | JP | 6878071 | B2 | 26 May 2021 |
| US | 2005060625 | A1 | 17 March 2005 | WO | 2005010932 | A2 | 03 February 2005 |
| | | | | US | 2006156122 | A1 | 13 July 2006 |
| | | | | US | 7032148 | B2 | 18 April 2006 |
| | | | | US | 7735049 | B2 | 08 June 2010 |
| US | 2018120378 | A1 | 03 May 2018 | TW | I612317 | B | 21 January 2018 |
| | | | | TW | 201818089 | A | 16 May 2018 |
| | | | | US | 10324130 | B2 | 18 June 2019 |
| US | 10908213 | B1 | 02 February 2021 | | None | | |
| US | 5867507 | A | 02 February 1999 | US | 6021513 | A | 01 February 2000 |
| | | | | JP | H09178822 | A | 11 July 1997 |
| | | | | TW | 298619 | B | 21 February 1997 |
| | | | | KR | 970051348 | A | 29 July 1997 |
| | | | | JP | 3710070 | B2 | 26 October 2005 |
| | | | | KR | 100234649 | B1 | 15 December 1999 |
| US | 7925947 | B1 | 12 April 2011 | | None | | |
| US | 2003101395 | A1 | 29 May 2003 | US | 6961885 | B2 | 01 November 2005 |
| US | 2006101316 | A1 | 11 May 2006 | US | 7222277 | B2 | 22 May 2007 |

Form PCT/ISA/210 (patent family annex) (January 2015)

INTERNATIONAL SEARCH REPORT
Information on patent family members

International application No.

**PCT/CN2021/109508**

| Patent document cited in search report | | | Publication date (day/month/year) | Patent family member(s) | | | Publication date (day/month/year) |
|---|---|---|---|---|---|---|---|
| US | 2008256274 | A1 | 16 October 2008 | US | 7823034 | B2 | 26 October 2010 |
| US | 2005240848 | A1 | 27 October 2005 | | None | | |
| US | 8533546 | B1 | 10 September 2013 | | None | | |
| US | 2004133831 | A1 | 08 July 2004 | | None | | |
| JP | 2009092531 | A | 30 April 2009 | | None | | |

Form PCT/ISA/210 (patent family annex) (January 2015)